Europäisches Patentamt

European Patent Office

Office européen des brevets

(11) Publication number: **0 233 824**
**A2**

# (12) EUROPEAN PATENT APPLICATION

(21) Application number: **87400353.6**

(22) Date of filing: **18.02.87**

(51) Int. Cl.⁴: **H 05 K 5/06**
**H 01 L 21/52, H 01 L 23/06**

(30) Priority: **19.02.86 US 831005**

(43) Date of publication of application:
**26.08.87 Bulletin 87/35**

(84) Designated Contracting States: **DE FR GB**

(71) Applicant: **ISOTRONICS, INC.**
**Industrial Park**
**New Bedford Massachusetts 02745 (US)**

(72) Inventor: **Duff, Raymond J.**
**23 Mishawum Drive**
**So. Dartmouth Massachusetts 02748 (US)**

**Overall III Sidney R.**
**Route 212 -Box 14**
**Lake Hill New York 12448 (US)**

(74) Representative: **Levesque, Denys et al**
**Cabinet Beau de Loménie 55, rue d'Amsterdam**
**F-75008 Paris (FR)**

(54) **Microcircuit package.**

(57) A flat housing package for microcircuits constructed entirely of metal with a stainless steel, cold-rolled steel, 52 alloy, or KOVAR frame (10) and an alumina/copper alloy base (20) and the process for brazing the components to one another. The brazing process involves heating the frame (10) and (20) base in three different heating zones and permits brazing at temperatures above 800°C. The package has good heat transfer characteristics and electrical connections between the microcircuit substrates and the housing can be reworked without disturbing the brazed seal between the frame and the base.

FIG 3

## Description

This invention pertains to all-metal, flat structural housings for microcircuits. These all-metal housings are constructed of four principal components. A frame is constructed of interconnected side support elements with apertures present on two opposing sides of the frame. Electrical leads pass through each of the apertures and are normally glass-sealed therein. Microcircuit substrates are affixed to a base, the latter having been firmly affixed to the frame. A lid is also present and is attached to the structural housing after the microcircuit has been installed. The frame component has been composed of various metal alloys. "KOVAR" is one such material and is the trademark for an iron-nickel-cobalt alloy manufactured by Westinghouse Corporation. This alloy possesses a thermal expansion coefficient very close to that of 96% alumina which is the substance in which most microcircuit substrates are housed. Thus, it is possible to solder the substrates directly onto the "KOVAR" material. Due to its very low coefficient of thermal conductivity, approximately 0.17 $(J/cm^2).(cm/s.°C)$, "KOVAR" is inadequate to properly dissipate heat from the power chips to a heat sink mounted below the base of the structural housing. The only feasible solution would be to employ a thin base to reduce the distance that the heat has to travel before reaching the heat sink. The rigidity of the base, however, is reduced in strength by such a construction.

Microcircuit structural housings have also been constructed of stainless steel or cold-rolled steel. However, these materials have structural disadvantages as well. Both materials possess coefficients of thermal expansion greater than 96%. Therefore, it is not feasible to braze the alumina microchip substrates directly to a base section composed of stainless steel or cold-rolled because thermal cracking will develop in the substrate during use. As an alternative to brazing, an epoxy can be used to affix the alumina substrates to the base. However, due to both steel materials and the epoxy possessing a low coefficient of heat transfer, inefficient thermal conduction results between the power chip and the heat sink, similar to drawbacks present in structural housings made of "KOVAR".

Another type of all-metal structural housing involves further attempts to construct a housing where alumina substrates could be securely attached to the base portion without sacrificing efficient heat transfer between the power chip and the heat sink. The microcircuit housing is constructed of a copper base and a 316 stainless steel frame where both components are connected using a braze of gold/tin, gold/germanium, or the like. The alumina substrates are mounted to the housings by attaching the substrates to a beryllia pad, the latter soldered directly to the copper base. The beryllia/copper base housings, however, possess two significant drawbacks. First of all, the size of the beryllia pad is crucial to the structural integrity of the housing. The pads must be large enough to provide good electrical isolation; however, if they are too large, some cracking may result due to thermal expansion. The optimal size for the pads has been determined to be a disk with a diameter of approximately 6,35 mm. The second drawback relates to the brazing material used to affix the copper base to the steel frame. Gold alloy brazing materials form a continuous seal at brazing temperatures below 460°C. The use of higher temperatures results in base portions with undesirable structural irregularities that evolve during the cooling process. The low annealing temperatures, therefore, greatly restrict the number of braze alloys that are available to affix the microcircuit substrates to the housing package.

Another structural housing embodiment utilizes a frame composed of "KOVAR" and a molybdenum base. Possible brazing materials included gold/tin, gold/germanium, and lead/silver. Each provides the necessary hermetic seal between the frame and the base; however, the brazing process requires temperatures above 500°C. As before, such high annealing temperatures produce structural irregularities in the base during the cool down phase of the brazing procedure.

The prior art, therefore, consists of all-metal structural housings for microcircuit substrates that possess either insufficient thermal conductivity or poor structural integrity.

The invention pertains to a flat housing package for microcircuits composed of a frame with glass sealed electrical leads and a base composed of an alumina/copper alloy and the method for brazing the frame to the base. The method of brazing involves heating the frame, braze, and base structure in three heating zones possessing progressively higher temperatures which can exceed 800°C. Despite the high annealing temperatures, the microcircuit package maintains a high degree of structural integrity and hardness. An additional advantage is that a greater number of soldering materials are available to the user such that he is able to remove and rework the microcircuits installed within the package without injury to the seal between the base and the frame.

These and other features of the invention will be better understood from the following detailed description, taken together with the drawings, wherein:

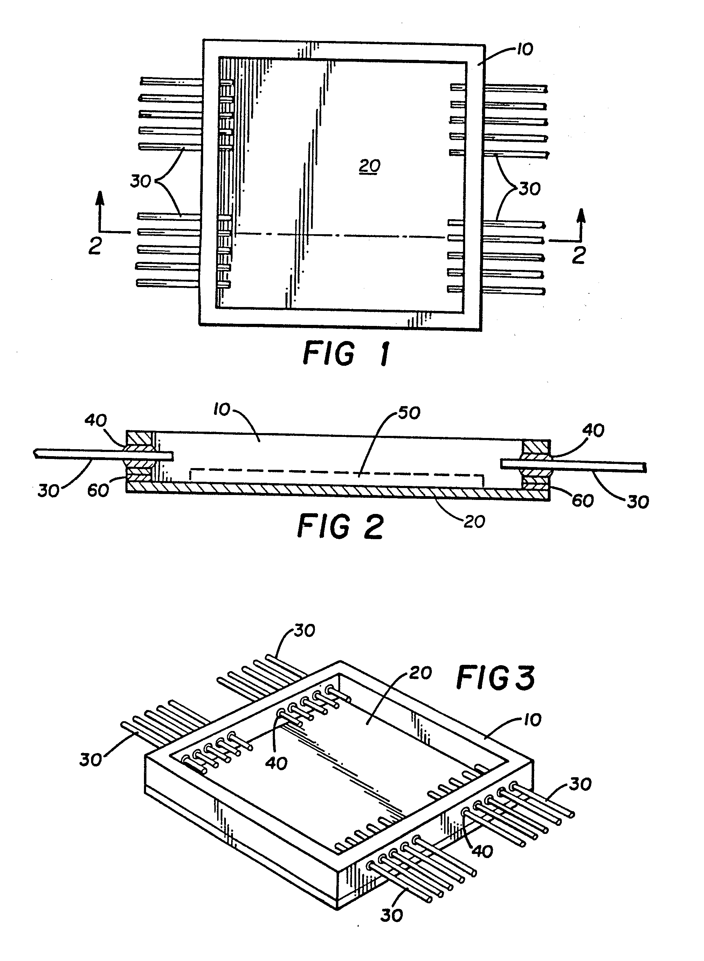

Fig. 1 is a plan view of a flat housing package with a frame, base, and electrical leads,

Fig. 2 is a cross-sectional view taken along the 2-2 axis of Fig. 1,

Fig. 3 is a prospective view of the flat housing package,

Fig. 4 is the heating profile for the brazing process shown in Example 1 using a gold/germanium braze,

Fig. 5 is the heating profile for the brazing process in Example 2 using a gold/tin braze, and

Fig. 6 is the heating profile for the brazing process in Example 3 using a copper/silver braze.

The flat structural housing for microcircuits, as shown in the accompanying drawings, is constructed of a frame 10 and a base 20. The metallic material of which the frame is composed can be either KOVAR, cold-rolled steel, 52 alloy (52% nickel, 48% iron), or stainless steel. The base is made of an alloy of alumina and copper distributed under the trademark GLIDCOP. The alloy exhibits good thermal conductivity and strength after elevated temperature exposure. Electrical leads 30 are installed in apertures located in two opposing sides of the frame. The leads are affixed to the frame with a seal 40 by employing the process of compression glass-sealing, which is well known in the art.

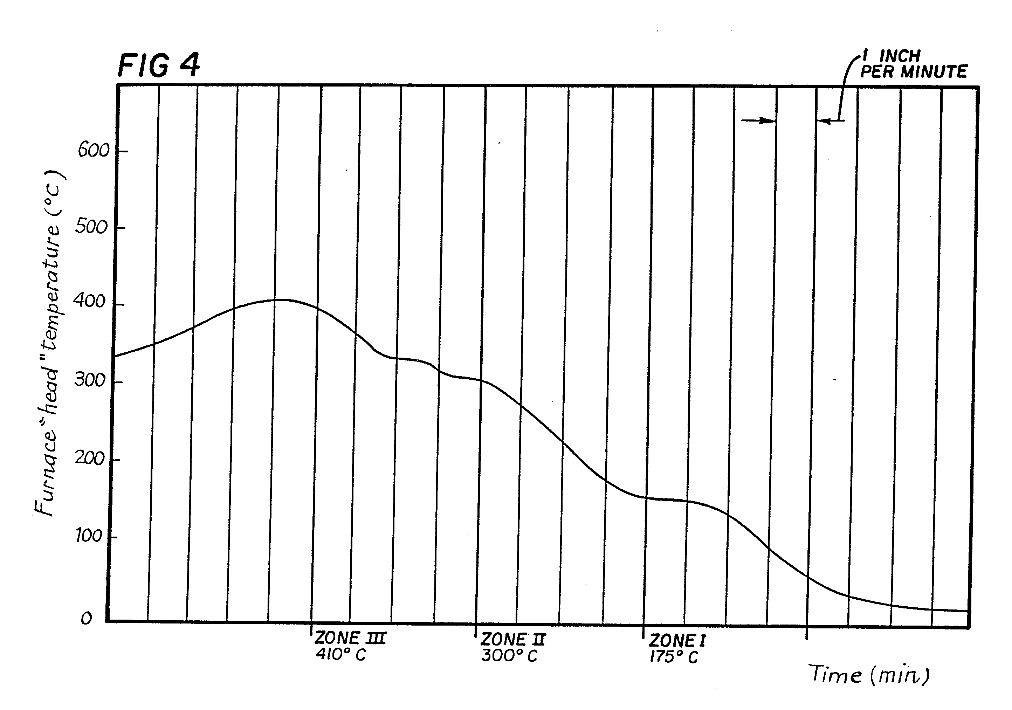

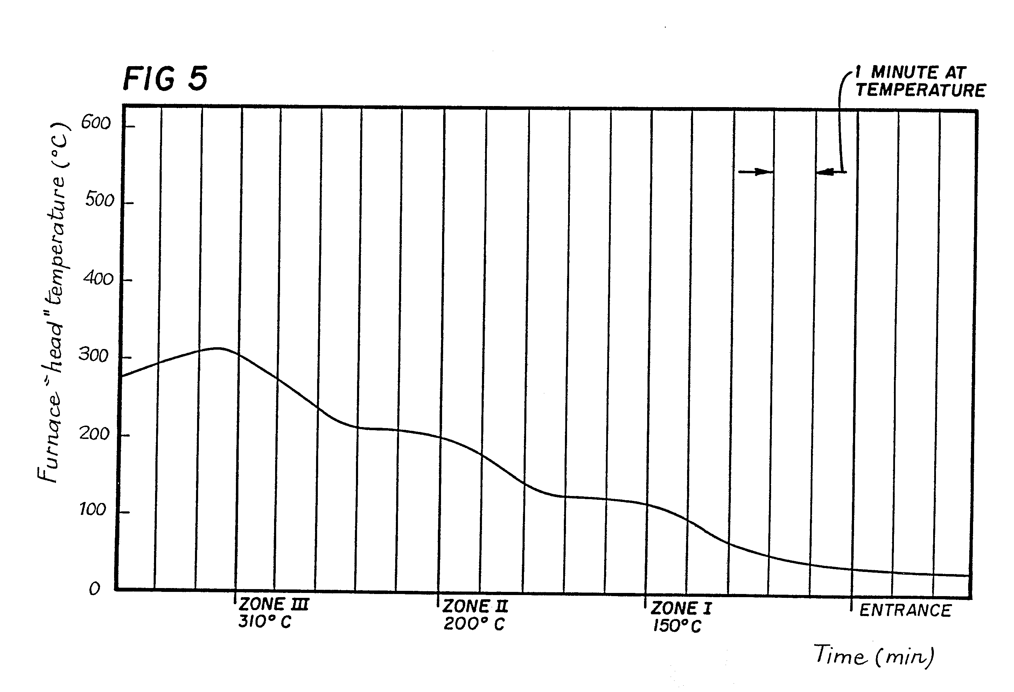

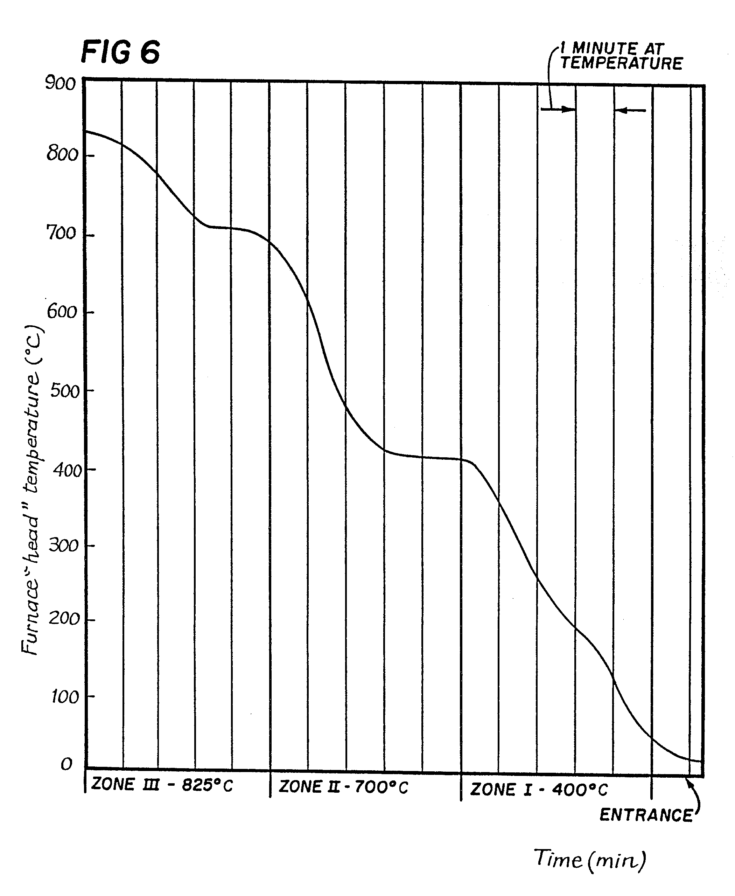

The frame is firmly bound to the alumina/copper base by braze 60 using a step-wise heating process that permits brazing to be performed at temperatures in excess of 800°C. This is achieved by passing the frame, base and braze unit through three heating zones, see Examples 1, 2, 3 and Figs. 4, 5, and 6, each zone maintained at a progressively higher temperature than the one before it. During the brazing process, the structural housing unit remains in each heating zone for approximately the same amount of time and is passed from one heating zone to the next without any significant environmental temperature drop; even where brazing occurs above 800°C. The result is a structurally sound package with a 70 F Rockwell Hardness.

A microcircuit substrate 50, for example, a power chip, is mounted to the base by using solder or an adhesive. The leads to the chip are then soldered to the inner terminal ends of electrical leads 30. A lid made of KOVAR, 52 alloy, cold-rolled steel, or stainless steel can be mounted to the open end of the structural housing after the microcircuit chip has been attached.

The brazing process can be better understood by referring to Examples 1, 2, and 3, that follow, and heating profiles for the process in Figs. 4, 5 and 6, respectively.

**EXAMPLE 1:** A frame, GLIDCOP base, and a gold/germanium braze (brazing temperature 350°C); heating zone temperatures of 175°C, 300°C, and 410°C; time in each zone, 4 minutes.

**EXAMPLE 2:** A frame, GLIDCOP base and a gold/tin braze (brazing temperature 280°C); heating zone temperatures 150°C, 200°C, and 310°C; time in each zone, 5 minutes.

**EXAMPLE 3:** A frame, GLIDCOP base, and a copper/silver braze (brazing temperature 780°C); heating zone temperatures, 400°C, 700°C, and 825°C; time in each zone, 5 minutes.

The present invention is not limited by the above solely exemplary detailed description. Modifications and substitutions by those skilled in the art are considered within the scope of the present invention. Therefore, the present invention is not to be considered limited except by the following claims.

## Claims

1. A flat structural housing for electronic microcircuits comprising:
a frame (10) composed of a metal containing iron having electrical leads extending therethrough and glass-sealed to said frame;
a flat alumina/copper alloy base (20);
said frame forming the side walls of said structural housing and being brazed to said alumina/copper alloy base to form a continuous seal between said frame and said base; and
said brazing having been performed after said electrical leads were glass-sealed in said frame.

2. The structural housing of claim 1 wherein said metal frame (10) is made of KOVAR.

3. The structural housing of claim 1 wherein said metal frame (10) is made of 52 alloy.

4. The structural housing of claim 1 wherein said metal frame (10) is made of cold-rolled steel.

5. The structural housing of claim 1 wherein said metal frame (10) is made of stainless steel.

6. The structural housing of claim 1 containing a microcircuit substrate (50) which is soldered to said base (20).

7. The structural housing of claim 6 wherein a power chip is mounted on said microcircuit substrate (50).

8. The structural housing according to any of claims 1 to 7 further including a lid welded to said frame (10), said lid composed of a metal containing iron.

9. The structural housing of claim 8 wherein said metal lid is composed of KOVAR.

10. The structural housing of claim 8 wherein said metal lid is composed of 52 alloy.

11. The structural housing of claim 8 wherein said metal lid is composed of stainless steel.

12. The structural housing of claim 8 wherein said metal lid is composed of cold-rolled steel.

13. The method of manufacturing a flat housing package for electronic microcircuits comprising:
glass-sealing electrical leads (30) in apertures of a frame (10) composed of a metal containing iron,
mounting said frame to a base (20) composed of an alumina copper alloy with a braze (60) disposed therebetween;
placing said frame (10), braze (60), base (20) unit in a heating apparatus capable of a multiplicity of heating zones at different temperatures; and
exposing said frame, braze, base unit to at least two successive heating zones with each of said heating zones at a higher temperature than the heating zone before it.

14. The method according to claim 13 wherein said electrical leads (30) are glass-sealed in a KOVAR frame.

15. The method according to claim 13 wherein said electrical leads (30) are glass-sealed in a 52 alloy frame.

16. The method according to claim 13 wherein said electrical leads (30) are glass sealed in a cold-rolled steel frame.

17. The method according to claim 13 wherein said electrical leads (30) are glass-sealed in a stainless steel frame.

18. The method according to any of claims 13 to 17 wherein a gold/tin braze is used to bind said base to said frame.

19. The method according to any of claims 13 to 17 wherein a gold/germanium braze is used to bind said base to said frame.

20. The method according to any of claims 13 to 17 wherein a copper/silver braze is used to bind said frame to said base.

21. The method according to claim 18 wherein the brazing is performed successively in temperature zones of 150°C, 200°C, and 310°C.

22. The method according to claim 19 wherein the brazing is performed successively in temperature zones of 175°C, 300°C, and 410°C.

23. The method according to claim 20 wherein the brazing is performed successively in temperature zones of 400°C, 700°C, and 825°C.

0233824

FIG 1

FIG 2

FIG 3

FIG 4

Furnace "head" temperature (°C)

600
500
400
300
200
100
0

I INCH
PER MINUTE

ZONE III
410° C

ZONE II
300° C

ZONE I
175° C

Time (min)

0233824

FIG 5

1 MINUTE AT TEMPERATURE

Furnace "head" temperature (°C)

ZONE III 310° C

ZONE II 200° C

ZONE I 150° C

ENTRANCE

Time (min)

FIG 6

0233824